# EUROPÄISCHE PATENTSCHRIFT

(11) **EP 3 698 067 B1**
(45) Veröffentlichungstag und Bekanntmachung des Hinweises auf die Patenterteilung: **10.01.2024**
(21) Anmeldenummer: 18793189.4
(22) Anmeldetag: 16.10.2018
(51) Int. Cl.: F16F 7/10, F16F 7/116, F16F 15/02, F16F 15/06, F16F 7/104

(54) **SCHWINGUNGSTILGER, INSBESONDERE FÜR EINEN SCHALTSCHRANK**
VIBRATION ABSORBER, IN PARTICULAR FOR A CONTROL CABINET
AMORTISSEUR DE VIBRATION, EN PARTICULIER POUR UNE ARMOIRE DE DISTRIBUTION

(30) Priorität: 18.10.2017 DE 102017218641
(43) Veröffentlichungstag der Anmeldung: 26.08.2020
(73) Patentinhaber: Framatome GmbH, 91052 Erlangen (DE)
(72) Erfinder: MOUSSALLAM, Nadim, 91052 Erlangen (DE); GEISS, Manfred, 35321 Laubach (DE)
(74) Vertreter: Lavoix
(86) Internationale Anmeldenummer: PCT/EP2018/078209
(87) Internationale Veröffentlichungsnummer: WO 2019/076879

(56) Entgegenhaltungen:
- EP-A2- 0 204 330
- WO-A1-2005/005857
- WO-A1-2014/195575
- WO-A2-2016/132394
- CN-A- 104 819 239
- KR-A- 20110 108 913
- US-A1- 2013 075 209

## Beschreibung

Die Erfindung betrifft einen Schwingungstilger und einen Schaltschrank mit einem derartigen Schwingungstilger.

Als Schwingungstilger werden besondere Arten von Schwingungsdämpfern bezeichnet, die an einem Objekt befestigt werden, um dieses hinsichtlich einer massiven Schwingungsanregung, etwa durch seismische oder andere Einflüsse (insbesondere Aufprall anderer Objekte) zu schützen. Ein derartiger Schwingungsdämpfer, der im englischen Sprachraum auch als "Tuned Mass Damper" bezeichnet wird, weist üblicherweise als Hauptelemente eine schwingend gelagerte Masse, kurz Schwingungsmasse, sowie zugehörige Federelemente und Dämpferelemente auf, die eine gedämpfte Schwingung der Schwingungsmasse relativ zum zu schützenden Objekt ermöglichen. Die Auslegung der genannten Komponenten ist dabei derart, dass eine hinsichtlich des erwarteten Lastfalls kritische Eigenfrequenz des Objekts bei dem aus Objekt und Schwingungstilger gebildeten Gesamtsystem unterdrückt oder in unkritische Bereiche verschoben wird. Dadurch wird eine Dämpfung des Gesamtsystems bei der Anregungsfrequenz erzielt. Auslegungsparameter sind dabei vor allem die Masse (Gewicht), die Federsteifigkeit und die Dämpfung (Dissipation).

Aus KR 10-2011-0108913 A ist ein Schwingungstilger mit den Merkmalen des Oberbegriffs von Anspruch 1 bekannt, der auf einem Schaltschrank eines Kernkraftwerks angebracht ist, um die darin befindlichen elektrischen bzw. elektronischen Komponenten im Falle seismischer Anregung oder bei sonstigen induzierten Vibrationen vor zur großer Belastung infolge von Beschleunigungskräften zu schützen. Das ist insbesondere bei einem I&C Schaltschrank wichtig, der Bauteile der Kraftwerkssteuerung beinhaltet (I&C = Instrumentation and Control).

Der dort offenbarte Schwingungstilger weist eine in einem quadratischen Kasten mit Abstand zum Rand angeordnete und reibungsarm auf Kugeln gelagerte Schwingungsmasse auf. Eine Mehrzahl von Schraubenfedern, die zwischen der Schwingungsmasse und dem Rand des Kastens eingespannt sind, bewirkt bei seitlicher Auslenkung der Schwingungsmasse eine Rückstellung in die Ruhelage. Die Schraubenfedern werden bei einer Schwingung des Systems in Längsrichtung gestaucht oder gestreckt. Eine Dämpfung der Schwingung wird dabei durch viskose Schwingungsdämpfer erzielt, die parallel zu den Schraubenfedern zwischen der Schwingungsmasse und dem Rand des umgebenden Kastens eingespannt sind.

Typischerweise besitzt ein Schaltschrank einen rechteckförmigen Querschnitt und weist unterschiedliche Schwingungseigenmoden in Bezug auf die Längsrichtung und die Querrichtung auf. Bei dem genannten Schwingungstilger gemäß KR 10-2011-0108913 A kann zwar eine gewisse Anpassung vorgenommen werden, indem für die Quer- und die Längsrichtung unterschiedliche Federsteifigkeiten und Dämpfungskonstanten eingestellt bzw. gewählt werden, jedoch ist diese Anpassung in der Praxis häufig nicht ausreichend. Außerdem benötigen die viskosen Schwingungsdämpfer eine regelmäßige Inspektion und Wartung.

WO2016/132394 A2 beschreibt eine rheologische Mehrzweck-Hystereseeinrichtung.

Aufgabe der Erfindung ist es, einen wartungsarmen und robusten Schwingungsdämpfer der genannten Art anzugeben, der sich besonders flexibel an unterschiedliche Eigenmoden in verschiedenen Raumrichtungen anpassen lässt, und der dadurch insbesondere bei Verwendung an/auf einem Schaltschrank eine effektive Reduktion seismischer und ähnlicher Schwingungsanregungen bewirkt.

Dier genannte Aufgabe wird erfindungsgemäß durch einen Schwingungstilger mit den Merkmalen des Anspruchs 1 gelöst.

Demnach ist Gegenstand der Erfindung ein passiver Schwingungstilger, insbesondere für einen Schaltschrank, mit einer eine Längs- und eine Querrichtung aufweisenden Tragstruktur und einer mittels Federelementen in Längs- und Querrichtung schwingend gelagerten zentralen Schwingungsmasse, wobei zumindest eine periphere Schwingungsmasse in Längsrichtung gleitend auf der zentralen Schwingungsmasse gelagert und relativ zu ihr beweglich ist, und wobei eine periphere Schwingungsmasse in Querrichtung gleitend auf der zentralen Schwingungsmasse gelagert und relativ zu ihr beweglich ist.

Jede der peripheren Schwingungsmassen ist mittels einer Anzahl von Federelementen an der Tragstruktur befestigt.

Der Begriff "gleitend gelagert" ist hier und im Folgenden in einem weiten Sinne zu verstehen und umfasst auch eine rollende bzw. abrollende Lagerung, etwa mit Hilfe von Kugellagern.

Vorteilhafte Ausgestaltungen gehen aus den abhängigen Ansprüchen sowie aus der nachfolgenden Beschreibung in Verbindung mit den zugehörigen Zeichnungen hervor.

Die Erfindung geht von der Überlegung aus, dass ein Schaltschrank verschiedene Hauptschwingungsmoden mit verschiedenen Eigenfrequenzen in der horizontalen Längs- und Querrichtung (nachfolgend: x- und y- Richtung) aufweist. Um eine optimale Schwingungsdämpfung zu erreichen, müssten deshalb eigentlich zwei Schwingungstilger mit entsprechend verschieden eingestellten Dämpfungscharakteristiken übereinander auf dem Schaltschrank angeordnet werden, was zu einem unerwünscht hohen Gesamtgewicht und Platzbedarf führen würde.

Die vorliegende Erfindung beschreitet daher einen anderen Weg, indem sie eine zentrale (innere) Schwingungsmasse vorsieht, die in beiden Richtungen Schwingungen um eine Ruhelage ausführen kann, sowie zumindest zwei periphere (äußere) Schwingungsmassen. Von den peripheren Schwingungsmassen kann zumindest eine lediglich in x-Richtung schwingen, wobei sich die zentrale Schwingungsmasse entsprechend in x-Richtung mitbewegt, sich in y-Richtung jedoch unabhängig bewegen kann. Die Kopplung ist bevorzugt dadurch verwirklicht, dass die genannte periphere Schwingungsmasse auf einem entsprechend ausgerichteten Führungselement der zentralen Schwingungsmasse in y-Richtung gleitend gelagert ist. Zusätzlich ist eine gleitende Führung der peripheren Schwingungsmasse in der dazu senkrechten Richtung, also in x-Richtung durch an der Tragstruktur angeordnete Führungselemente vorgesehen. Zumindest eine weitere periphere Schwingungsmasse weist analog in der y-Richtung einen durch entsprechende Führungselemente an der Tragstruktur verwirklichten Freiheitsgrad der Bewegung auf. Durch Gleitlagerung auf einem Führungselement der zentralen Schwingungsmasse ist selbige in y-Richtung an die Bewegung der genannten peripheren Schwingungsmasse gekoppelt, während sie ihr gegenüber in x-Richtung unabhängig beweglich ist.

Besonders bevorzugt ist eine kreuzartige symmetrische Anordnung mit zwei ausschließlich in x-Richtung beweglichen peripheren Schwingungsmassen, zwei ausschließlich in y-Richtung beweglich peripheren Schwingungsmassen und der zentralen, relativ zur Tragstruktur in beiden Richtungen beweglichen Schwingungsmasse in der Mitte dazwischen.

Jede der peripheren Schwingungsmassen ist über zumindest ein Federelement an die umgebende Tragstruktur gekoppelt und damit einer Rückstellkraft in Richtung Ruhelage unterworfen. Bevorzugt ist jede periphere Schwingungsmasse über zwei symmetrisch zur ihr angeordnete Federelemente an die Tragstruktur gekoppelt. Bei den bevorzugt vier peripheren Schwingungsmassen kommen daher bevorzugt vier Gruppen von je zwei Federelementen zum Einsatz, insgesamt also acht Federelemente. Durch die bereits erwähnte Kopplung der peripheren Schwingungsmassen an die zentrale Schwingungsmasse ist auch die zentrale Schwingungsmasse einer Rückstellkraft in Richtung Ruhelage unterworfen. Zugleich wirken die Federelemente schwingungsdämpfend.

Man kann es auch so ausdrücken, dass die vorzugsweise vom Gewicht her dominierende zentrale Schwingungsmasse - bei stets gleichbleibender Ausrichtung - in beiden Richtungen Schwingungen um eine Ruhelage ausführen kann, wobei die erste Gruppe von üblicherweise im Vergleich zur zentralen Schwingungsmasse leichteren peripheren Schwingungsmassen in x-Richtung zwangsweise mitbewegt wird, aber ihre y-Position beibehält, und umgekehrt für die zweite Gruppe. Durch die zwangsweise Mitbewegung der jeweiligen peripheren Schwingungsmasse werden die zugeordneten Federelemente beansprucht und die gewünschten Rückstellkräfte erzeugt.

Durch die Einstellung der in der jeweiligen Richtung wirksamen Massen sowie durch die Auswahl der zugehörigen Federsteifigkeiten kann eine differentielle Einstellung des Schwingungsverhaltens in beiden Richtungen erfolgen. Dadurch kann auf einfache Weise und mit einer minimalen Anzahl unterschiedlicher Federtypen eine optimale Anpassung an die zu eliminierenden, unterschiedlichen Eigenfrequenzen in beiden Richtungen erfolgen. Eine Einstellung in x-Richtung mittels der entsprechenden peripheren Massen und Federelemente ist vollständig unabhängig von der Einstellung in y-Richtung, verstimmt diese also nicht, und umgekehrt. Da die Hauptmasse, nämlich die zentrale Schwingungsmasse, in Bezug auf das Gesamtsystem in beiden Richtungen schwingungsdämpfend wirkt, ist das Gesamtgewicht des Schwingungstilgers vergleichsweise niedrig.

Bei den Federelementen handelt es sich bevorzugt um Federn aus schraubenförmig um eine Längsachse gewickelten oder gewundenen Stahldraht oder Stahlseil(en), kurz Stahldrahtfedern oder Drahtstahlfedern oder Drahtseilfedern (im Englischen: Wire Rope Springs), die derart ausgerichtet sind, dass sie im Querschnitt betrachtet in radialer Richtung mit Zug- oder Druckkräften beaufschlagt werden. Die Kräfte greifen also im Wesentlichen senkrecht zur Längsachse der jeweiligen Feder an ihr an. Damit ist eine besonders kompakte Bauweise bei hinreichend großen Federwegen realisierbar. Drahtseilfedern geben nicht nur Steifigkeit, sondern tragen darüber hinaus auch zur Trockendämpfung bei durch Reibung zwischen den Stahldrähten bzw. zwischen den einzelnen Strängen oder Litzen des Drahtseils. Derartige Federn werden auch als Metallkabel- oder Metallfaser-Schockdämpfer bezeichnet. Alternativ oder zusätzlich können beispielsweise herkömmliche Schraubenfedern verwendet werden, die bevorzugt so eingebaut sind, dass sie in Längsrichtung auf Zug und/oder Druck beansprucht werden.

Des Weiteren ist es zweckmäßig, dissipative Elemente oder Dämpfer einzusetzen, die - über die den Federelementen intrinsische Dämpfung hinaus - zur Dämpfung der Systemschwingungen beitragen. Im Rahmen der Erfindung wurde erkannt, dass die üblicherweise zu diesem Zweck verwendeten viskosen Dämpfer bei der Verwendung auf der Oberseite eines Schaltschranks eine Gefahr darstellen. Unter ungünstigen Umständen könnte nämlich ein derartiger Dämpfer leck schlagen und eine viskose Dämpfungsflüssigkeit freisetzen, welche häufig giftig, brennbar und/oder elektrisch leitend ist - allesamt hochgradig unerwünschte Eigenschaften bei einer Freisetzung und insbesondere bei einem Hineinlaufen in das Innere des Schaltschranks. Zur Vermeidung derartiger Risiken werden bei dem erfindungsgemäßen Schwingungstilger ausschließlich reibungsbasierte Dämpfer eigesetzt. Derartige Trockendämpfer verzehren die Schwingungsenergie durch Gleitreibung zwischen zwei trockenen Reibflächen und sind im Gegensatz zu viskosen Dämpfern auch über viele Jahre hinweg wartungsfrei.

Insbesondere sind zu diesem Zweck an der Tragstruktur des Schwingungstilgers Reibpolster oder Reibeläge angebracht, an/auf denen die schwingenden Massen gleitend gelagert sind. Dies betrifft die zentrale Schwingungsmasse und gegebenenfalls auch die peripheren Schwingungsmassen. Durch gezielte Beaufschlagung mit einem Anpressdruck mittels einer zugeordneten, vorzugsweise federbelasteten Spannvorrichtung lässt sich die Reibung deutlich über den durch das Eigengewicht der Massen erreichbaren Wert erhöhen und vor allem zielgerichtet einstellen.

Ein weiterer Vorteil des hier beschriebenen Schwingungstilgers ist seine kompakte, auf die Geometrie eines Schaltschranks abgestimmte Bauform. Er passt damit ohne seitlichen Überstand auf die Deckenwand am oberen Ende, und er bietet trotzdem den schwingenden Massen genügend Platz für eine Auslenkung von einigen Zentimetern aus der Ruhelage.

Ein Ausführungsbeispiel der Erfindung wird nachfolgend anhand von Zeichnungen näher erläutert. Dabei zeigen:
- FIG. 1: eine perspektivische Ansicht eines Schaltschranks,
- FIG. 2: den Schaltschrank gemäß FIG. 1 mit einem auf seiner Oberseite montierten, hier nur schematisch dargestellten Schwingungstilger,
- FIG. 3: eine Draufsicht von oben auf ein Traggerüst des erfindungsgemäßen Schwingungstilgers,
- FIG. 4: eine Draufsicht von oben auf den Schwingungstilger insgesamt,
- FIG. 5: eine Seitenansicht des Schwingungstilgers,
- FIG. 6: eine Seitenansicht einer Schwingungsmasse des Schwingungstilgers mit einer zugehörigen Spannvorrichtung,
- FIG. 7: eine Seitenansicht einer Schwingungsmasse des Schwingungstilgers mit daran befestigten Zusatzgewichten,
- FIG. 8: eine Schnittansicht der Spannvorrichtung aus FIG. 6 im Detail, und
- FIG. 9: eine perspektivische Ansicht des Schwingungstilgers.

Gleiche oder gleichwirkende Teile sind in allen Figuren mit denselben Bezugszeichen versehen.

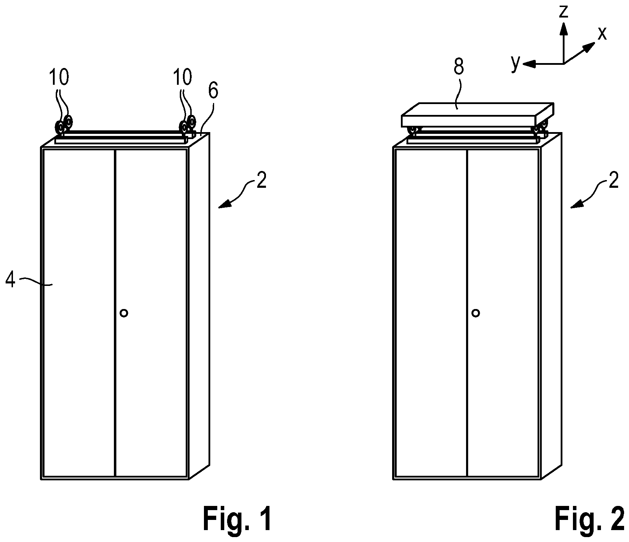

FIG. 1 zeigt eine perspektivische Ansicht eines Schaltschranks 2 herkömmlicher Bauart in Betriebsposition mit im Wesentlichen quaderförmiger Außenkontur. In seinem Innenraum nimmt der Schaltschrank 2 beispielsweise eine Anzahl von elektrischen oder elektronischen Komponenten auf. In einer der Seitenwände des Schaltschranks befindet sich eine Anzahl von Türen 4, um bedarfsweise einen Zugriff zum Innenraum von außen zu ermöglichen.

Gemäß der vorliegenden Erfindung ist an der Oberseite der in der Betriebsposition horizontal ausgerichteten rechteckförmigen Deckenwand 6 oder Deckenplatte des Schaltschranks 2 ein in FIG. 2 nur schematisch angedeuteter Schwingungstilger 8 befestigt, der auf die im Innenraum angeordneten Komponenten einwirkende seismische Schwingungen im Fall eines Erdbebens oder sonstige Vibrationen dämpfen soll. Im hier gezeigten Beispiel erfolgt die Befestigung des Schwingungstilgers 8 mit Hilfe von vier jeweils nahe den Ecken an der Oberseite der Deckenwand 6 vorhandenen ösenförmigen Halteelementen 10, die üblicherweise zum Anheben des Schaltschranks 2 durch eine Hebevorrichtung vorhanden sind. Die Befestigung kann selbstverständlich auch auf andere Weise erfolgen. In einer hier nicht dargestellten alternativen Variante kann der Schwingungstilger 8 im Inneren des Schaltschranks 2 angeordnet sein - bevorzugt möglich weit oben.

Die Quer- und die Längsrichtung der rechteckförmigen Deckenwand 6 definieren ein rechtwinkliges x-y-Koordinatensystem, auf welches im Folgenden Bezug genommen wird.

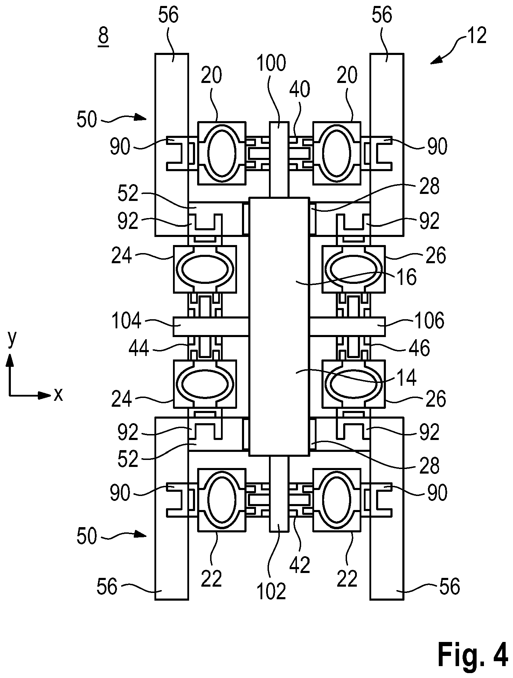

In FIG. 4 ist eine bevorzugte Ausführungsform des Schwingungstilgers 8 in einer Draufsicht von oben dargestellt. Der Schwingungstilger 8 weist einen auf die Kontur der Deckenwand 6 des Schaltschranks 2 abgestimmten rechteckförmigen Umriss auf, dessen Längs- und Querrichtung in der Einbaulage mit der Längs- und Querrichtung der Deckenwand 6 des Schaltschranks 2 übereinstimmen. Insofern entsprechen in der Einbaulage die Querrichtung der x-Richtung und die Längsrichtung der y-Richtung im oben definierten Koordinatensystem.

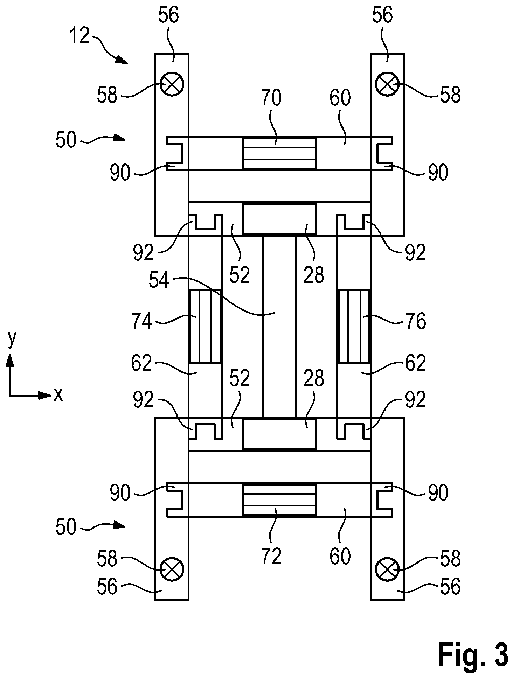

Wesentliche Bestandteile des Schwingungstilgers 8 sind eine in FIG. 3 isoliert dargestellte starre Tragstruktur 12, die in der Einbaulage in der beschriebenen Weise mit der Deckenwand 6 des Schaltschranks 2 verbunden ist, und eine in FIG. 4 erkennbare schwingend der Tragstruktur 12 gelagerte zentrale Schwingungsmasse 14. Die zentrale Schwingungsmasse 14 besitzt einen Zentralkörper 16 von länglicher Gestalt, beispielswese einen Quader, der entlang der y-Richtung ausgerichtet ist, mithin parallel zur Längsseite der Deckenwand 6 des Schaltschranks 2. Die zentrale Schwingungsmasse 14 ist derart in/an/auf der Tragstruktur 12 gelagert, dass sie bei entsprechender Kraftanwendung sowohl in x- als auch in y-Richtung entgegen einer durch Federelemente 20, 22, 24, 26 bewirkten Rückstellkraft aus einer Ruheposition ausgelenkt wird und anschließend in diese zurückkehrt. Mit anderen Worten kann sich die zentrale Schwingungsmasse 14 in beiden Richtungen relativ zur Tragstruktur 12 bewegen und eine Schwingung um die Ruhelage ausführen. Die maximale Auslenkung aus der Ruhelage (Verstellweg) wird beispielsweise durch Anschläge begrenzt, die zweckmäßigerweise an der Tragstruktur 12 selber angebracht oder ausgebildet sind. Alternativ kann auch eine Begrenzung durch die realisierbaren Federwege selber verwirklicht sein.

Die Tragstruktur 12 kann in einer nicht dargestellten Variante auch ganz oder teilweise in den Schaltschrank integriert sein.

Durch die weiter unten im Detail beschriebene Art der Lagerung kann im vorliegenden Beispiel keine Verkippung oder Verdrehung der zentralen Schwingungsmasse 14 gegenüber der in Ruhelage vorhandenen Längsausrichtung erfolgen. Mit anderen Worten kann sich die Längsachse des Zentralkörpers 16 nicht aus der y-Richtung herausdrehen, so dass keine Torsionsschwingungen anregbar sind. Es sind aber prinzipiell auch andere Lagerungen denkbar, bei denen eine Torsion möglich ist.

Bereits durch die Federelemente 20, 22, 24, 26 selber und ihre immanente Steifigkeit ist eine Dämpfung der Schwingung verwirklicht. Eine zielgerichtete Verstärkung der Dämpfung wird dadurch erzielt, dass die zentrale Schwingungsmasse 14 gleitend auf der Tragstruktur 12 (alternativ auf der Deckenwand 6 des Schaltschranks 2) gelagert ist, wobei vorteilhaftweise die Kontaktflächen durch ihre Oberflächenbeschaffenheit Reibflächen mit definiertem Reibungskoeffizienten bilden. Beispielsweise können hier Reibbeläge oder Reibpolster 28 zum Einsatz kommen. Dies ist exemplarisch in FIG. 3 oder 4 dargestellt: An der Oberseite der Tragstruktur 12 sind Reibbeläge oder Reibpolster 28 angebracht, auf denen der Zentralkörper 16 der zentralen Schwingungsmasse 14 gleitend aufliegt.

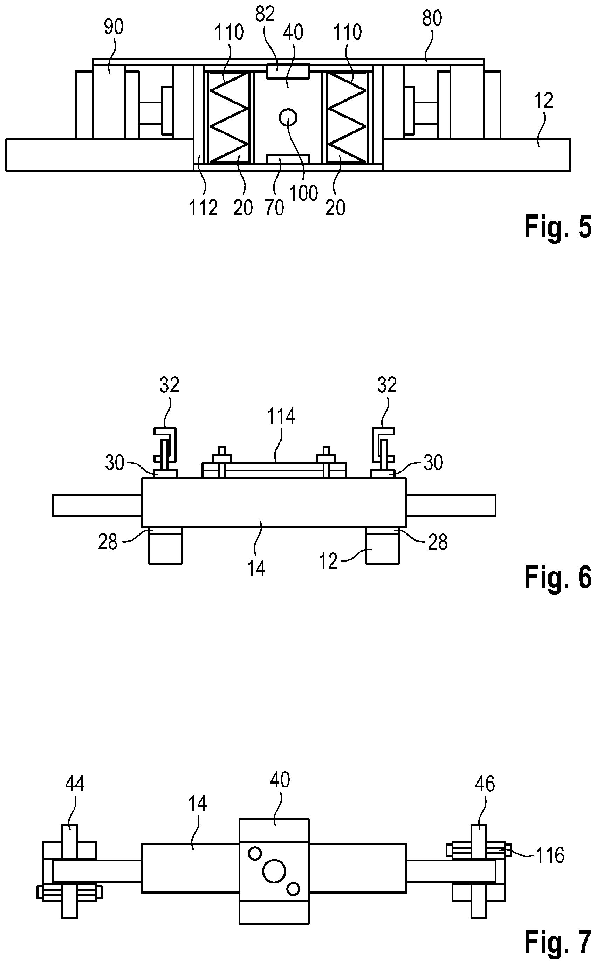

In einer vorteilhaften Ausgestaltung, die in FIG. 6 angedeutet ist, sind zudem Reibbeläge oder Reibpolster 30 vorhanden, die an der Oberseite des Zentralkörpers 16 aufliegen und von oben auf ihn drücken. Der Anpressdruck ist vorteilhafterweise durch mindestens eine zugehörige verstellbare Spannvorrichtung 32 einstellbar. Mit anderen Worten ist der Zentralkörper 16 zwischen den oberen Reibpolstern 30 und den unteren Reibpolstern 28 eingespannt und dadurch einer definiert einstellbaren Reibkraft unterworfen, so dass die Schwingungsdämpfung gezielt einstellbar ist. Für eine gleichmäßige Kraftverteilung können mehrere solcher Spannvorrichtungen vorhanden sein.

Um eine noch bessere Einstellung der Schwingungsdämpfung unter Berücksichtigung der im Allgemeinen für die x-Richtung und die y-Richtung verschiedenen Schwingungsmoden zu ermöglichen, sind neben der zentralen Schwingungsmasse 14 weitere Schwingungsmassen vorhanden. Eine erste Gruppe von peripheren Schwingungsmassen 40, 42 ist nämlich derart an das bislang beschriebene System angekoppelt, dass die jeweilige periphere Schwingungsmasse 40, 42 zwangsweise die Bewegung der zentralen Schwingungsmasse 14 in x-Richtung mitmacht, jedoch innerhalb eines vorgegebenen Verstellweges in y-Richtung relativ zur zentralen Schwingungsmasse 14 beweglich ist. Die Bewegung in x-Richtung wird durch zugehörige Federelemente 20, 22 gedämpft. In besonders vorteilhafter aber nicht zwingend notwendiger Ausgestaltung handelt es sich dabei um diejenigen Federelemente, die auch die Bewegung der zentralen Schwingungsmasse 14 dämpfen. Für eine zweite Gruppe von peripheren Schwingungsmassen 44, 46, denen die Federelemente 24, 26 zugeordnet sind, gilt Entsprechendes unter Vertauschung der Rollen von x- und y-Richtung.

Mit anderen Worten ist in der bevorzugten Ausführungsvariante die zentrale Schwingungsmasse 14 nicht direkt mittels Federelementen mit der Tragstruktur 12 verbunden. Vielmehr ist eine federnde Kopplung der zentralen Schwingungsmasse 14 mit der Tragstruktur 12 ausschließlich indirekt über diejenigen Federelemente 20, 22, 24, 26 verwirklicht, die mit den peripheren Schwingungsmassen 40, 42, 44, 46 einerseits und der Tragstruktur 12 andererseits verbunden sind. Die peripheren Schwingungsmassen 40, 42, 44, 46 sind also direkt mittels der Federelemente 20, 22, 24, 26 mit der Tragstruktur 12 verbunden bzw. gekoppelt. Wenn die zentrale Schwingungsmasse 14 sich beispielsweise in x-Richtung bewegt, nimmt sie die in dieser Richtung starr mit ihr gekoppelten zugehörigen peripheren Schwingungsmassen 40, 42 mit, die dann entgegen der wirksamen Rückstellkraft der Federn 20, 22 ausgelenkt werden. In y-Richtung gilt Entsprechendes.

Durch das System aus zentraler Schwingungsmasse 14 und peripheren Schwingungsmassen 40, 42, 44, 46 und den zugehörigen Federelementen 20, 22, 24, 26 kann eine optimierte Anpassung der Dämpfung an die in x- und y-Richtung unterschiedlichen Eigenfrequenzen des Schaltschranks 2 erfolgen. Da die zentrale Schwingungsmasse 14 eine dämpfende Funktion für beide Richtungen übernimmt, kann das Gewicht der gewissermaßen zur Feinabstimmung verwendeten peripheren Schwingungsmassen 40, 42, 44, 46 in der Regel deutlich kleiner ausfallen als das Gewicht der zentralen Schwingungsmasse 14.

Im vorliegenden Beispiel ist es zwar so, dass vorteilhafterweise - im Einklang mit den gewählten Begriffen - die zentrale Schwingungsmasse 14 innen liegt, während die peripheren Schwingungsmassen 40, 42, 44, 46 weiter außen angeordnet sind. Es sind aber prinzipiell auch andere Konfigurationen denkbar, etwa mit kleinen sekundären Schwingungsmassen mit jeweils einem Freiheitsgrad innerhalb einer großen primären Schwingungsmasse mit zwei Freiheitsgraden.

Im Folgenden werden einige Details der in den Zeichnungen dargestellten besonders vorteilhaften Implementierung des erfindungsgemäßen Schwingungstilgers 8 dargestellt:
Die in FIG. 3 in Draufsicht von oben dargestellte Tragstruktur 12, auch als Gestell oder Rahmen bezeichnet, weist zwei U-förmige Ausleger 50 auf, deren Öffnungen voneinander abgewandt sind. Die beiden U-förmigen Ausleger 50 liegen in der Einbauposition in einer gemeinsamen horizontalen Ebene und sind an der jeweiligen Basis 52 durch einen zentralen, entlang der y-Richtung ausgerichteten Träger 54 miteinander starr verbunden. Dieser Teil der Tragstruktur 12 bildet sich aus Stahlprofilen, bevorzugt Vierkantprofilen mit vorzugsweise quadratischem Querschnitt. An den Enden der entlang der y-Richtung ausgerichteten Schenkel 56 der U-förmigen Ausleger 50 befinden sich die Befestigungspunkte 58, ggf. mit geeigneten Befestigungsmitteln zum Schaltschrank 2. An der Oberseite der Stahlprofile befinden sich an geeigneter Stelle, hier an der jeweiligen Basis 52 der U-förmigen Ausleger 50, die Reibbeläge oder Reibpolster 28, auf denen die zentrale Schwingungsmasse 14 gleitend aufliegt.

Des Weiteren sind die Schenkel 56 des jeweiligen U-förmigen Auslegers 50 durch ein dazwischen liegendes, entlang der x-Richtung ausgerichtetes Flachprofil 60 miteinander verbunden. In analoger Weise sind zwischen den beiden U-förmigen Auslegern 50 parallel zum zentralen Träger 54 verlaufende Flachprofile 62 angeordnet. Auf den Flachprofilen 60, 62 sind jeweils schienenartige Führungselemente 70, 72, 74, 76 für die peripheren Schwingungsmassen 40, 42, 44, 46 ausgebildet, etwa in Form von Rillen, Nuten oder Erhöhungen (siehe weiter unten). Die durch die Führungselemente 70, 72, 74, 76 vorgegebenen möglichen Bewegungsrichtungen der peripheren Schwingungsmassen 40, 42, 44, 46 sind in FIG. 3 schematisch durch Längsrillen angedeutet. Konkret können sich die peripheren Schwingungsmassen 40, 42 in x-Richtung und die peripheren Schwingungsmassen 44, 46 in y-Richtung bewegen. Gemäß FIG. 5 können an der Unterseite der weiter unten näher erläuterten Deckelplatte 80 zusätzliche Führungselemente 82 in entsprechender Ausrichtung vorgesehen sein. Gegebenenfalls kann auch auf die bodenseitigen Führungselemente verzichtet werden und stattdessen ausschließlich deckelseitige Führungselemente vorgesehen sein.

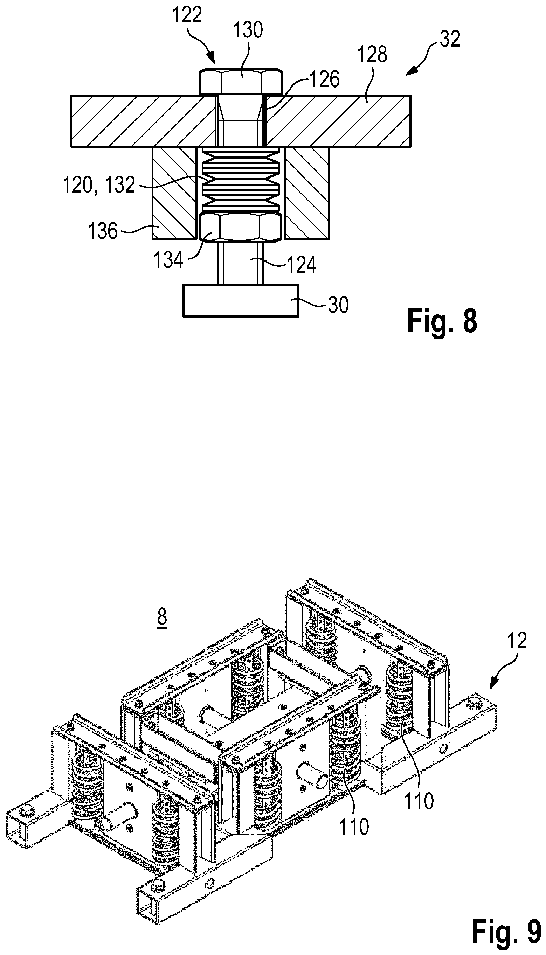

Schließlich weist die Tragstruktur 12 eine Mehrzahl von Vertikalträgern 90, 92 auf, die säulenartig von der vorgenannten horizontalen Ebene senkrecht nach oben abstehen. Insbesondere ist an jedem Schenkel 56 der U-förmigen Ausleger 50 ein derartiger Vertikalträger 90 angebracht. Darüber hinaus ist an der Basis 52 des U-förmigen Auslegers 50 jeweils zwischen dem Reibpolster 28 und dem weiter au-ßen liegenden Schenkel 56 ein derartiger Vertikalträger 92 angebracht. Insgesamt sind die Vertikalträger 90, 92 symmetrisch zu den beiden Mittelachsen der Tragstruktur 12 angeordnet. Sie bestehen vorzugsweise aus Stahlprofilen, insbesondere U-Profilen. Wie nachfolgend erläutert wird, bilden die Vertikalträger 90, 92 Befestigungs- oder Verankerungspunkte für die die Bewegung der schwingenden Massen dämpfenden Federelemente 20, 22, 24, 26. Darüber hinaus bilden sie an ihren nach oben abstehenden Enden Auflage- und Befestigungspunkte für eine in der Einbauposition horizontal ausgerichtete Deckelplatte 80, welche ein ungewolltes Herausspringen der schwingenden Massen aus der horizontalen Ebene nach oben verhindert. Anstelle einer flächigen Deckelplatte 80 können wie in FIG. 9 angedeutet auch mehrere Flachprofile oder dergleichen den Abschluss der Vorrichtung nach oben bilden.

Die Träger der Tragstruktur 12 bestehen bevorzugt aus metallischen Werkstoffen und sind an den Kontaktpunkten miteinander verschweißt, so dass eine stabile und verwindungssteife Konstruktion vorliegt. Als bevorzugter Werkstoff bietet sich Stahl an, aber auch beispielsweise Aluminium, insbesondere bei gewünschter Gewichtsreduktion. Alternativ kommen Verbundwerkstoffe in Betracht.

Wie in FIG. 4 zu erkennen, ist die zentrale Schwingungsmasse 14 entlang der Längsachse, also in y-Richtung der Tragstruktur 12 ausgerichtet und auf den Reibpolstern 28 mit Spiel sowohl in Längs- als auch in Querrichtung gelagert. An ihren beiden Stirnseiten weist die zentrale Schwingungsmasse 14 jeweils eine in y-Richtung gerichtete, angeformte oder mit dem Zentralkörper 16 fest verbundene Verlängerung auf, die als Träger und schienenartiges Führungselement 100, 102 - hier in Form eines Rundstabes - für eine periphere Schwingungsmasse 40, 42 dient. Die periphere Schwingungsmasse 40, 42 weist jeweils eine ringförmige Gestalt auf und ist mit geringem Spiel gleitend oder mittels Kugellagern abrollend auf dem Führungselement 100 gelagert. Auf diese Weise kann sie sich in y-Richtung innerhalb einer durch die Länge des Führungselements 100, 102 definierten Wegestrecke relativ zur zentralen Schwingungsmasse 14 bewegen, ist aber in x-Richtung an die Bewegung der zentralen Schwingungsmasse 14 gekoppelt. Vorteilhafterweise liegt die jeweilige periphere Schwingungsmasse 40, 42 bodenseitig gleitend auf einem Führungselement 70, 72 auf, welches an/auf dem Flachprofil 60 vorhanden ist. Diese Führungselemente 70, 72 sind derart beschaffen und ausgerichtet, dass die bereits beschriebenen Freiheitsgrade der Bewegung unterstützt werden.

Weiterhin weist die zentrale Schwingungsmasse 14 entlang der x-Richtung seitlich abstehende, Träger und Führungselemente 104, 106 bildende Verlängerungen aus, auf denen in analoger Weise zur obigen Beschreibung ebenfalls periphere Schwingungsmassen 44, 46 gleitend gelagert sind. Dabei können sich diese peripheren Schwingungsmassen 44, 46 in x-Richtung relativ zur zentralen Schwingungsmasse 14 bewegen, während sie in y-Richtung an die Bewegung der zentralen Schwingungsmasse 14 gekoppelt sind. Bodenseitig liegt die jeweilige periphere Schwingungsmasse 44, 46 gleitend auf einem Führungselement 74, 76 auf dem Flachprofil 62 auf. Die vorherige Beschreibung für die erste Gruppe von peripheren Schwingungsmassen 40, 42 gilt hier analog.

Wie bereits erwähnt, ist eine Rückstellung der schwingenden Massen in ihre Ruhelage und eine Dämpfung der Schwingung durch eine Mehrzahl von sich an der Tragstruktur abstützenden Federelementen 20, 22, 24, 26 vorgesehen. Die bevorzugte Federanordnung wird nachfolgend näher erläutert.

Erstens ist jede der durch die Führungselemente 70, 72 in x-Richtung beweglichen und in y-Richtung blockierten peripheren Schwingungsmassen 40, 42 über zwei nach außen gerichtete Federelemente 20, 22 mit den beiden Schenkeln 56 des U-förmigen Auslegers 50 verbunden. Bei dem jeweiligen Federelement 20, 22 handelt es sich bevorzugt um eine vertikal ausgerichtete längliche Feder 110 von bevorzugt schraubenförmiger Gestalt, insbesondere eine Drahtseilfeder, die einerseits an der peripheren Schwingungsmasse 40, 42 und andererseits an dem vom Schenkel 56 des U-förmigen Auslegers 50 nach oben abstehenden Vertikalträger 90 befestigt ist, wie man in der perspektivischen Darstellung gemäß FIG. 9 oder in der Seitenansicht gemäß FIG. 5 gut erkennt. Gegebenenfalls können zwischen den Federn 110 und den Vertikalträgern 90 als Adapter mit variabler Dicke fungierende Verbindungsplatten 112 liegen. Das heißt, die Federn 110 werden hier im Querschnitt gesehen durch die Schwingungen in Radialrichtung beansprucht, also zusammengedrückt oder auseinandergezogen. Jede der peripheren Schwingungsmassen 40, 42 kann sich damit entgegen der Rückstellkraft der Federelemente 20, 22 relativ zur Tragstruktur 12 um eine gewisse Wegstrecke in x-Richtung bewegen, und zwar zusammen mit der zentralen Schwingungsmasse 14. In y-Richtung hingegen kann sich die zentrale Schwingungsmasse 14 unabhängig von und relativ zu den peripheren Schwingungsmassen 40, 42 bewegen.

Zugleich sorgen die Federelemente 20, 22 für eine Rückstellung und Dämpfung der Schwingung der zentralen Schwingungsmasse 14 in x-Richtung, denn wenn diese in x-Richtung ausgelenkt wird, überträgt sich die Auslenkung über die dazwischen liegenden peripheren Schwingungsmassen 40, 42 auf die Federelemente 20, 22. Durch die Geometrie der Anordnung, bei der die zentrale Schwingungsmasse 14 gewissermaßen mittels der Federelemente 20, 22 zwischen den beiden Schenkeln 56 des U-förmigen Auslegers 50 eingespannt ist, wird letztlich auch eine Wegbeschränkung der zentralen Schwingungsmasse 14 in x-Richtung verwirklicht.

Obigen Ausführungen gelten sinngemäß für die zweite Gruppe von peripheren Schwingungsmassen 44, 46, die jeweils mittels Federelementen 24, 26 zwischen den beiden Trägern an der Basis 52 der U-förmigen Ausleger 50 eingespannt sind. Die Verankerung der Federelemente 24, 26 an der Tragstruktur 12 erfolgt in diesem Fall an den Vertikalträgern 92, die nach oben von den Basisträgern abstehen. Dadurch erfolgt eine Rückstellung und Dämpfung und letztlich auch eine Wegbeschränkung der Schwingung der zentralen Schwingungsmasse 14 in y-Richtung. Durch die gleitende Lagerung der peripheren Schwingungsmassen 44, 46 auf den in x-Richtung vom Zentralkörper 16 abstehenden Führungselementen 104, 106 ist sichergesellt, dass sich die zentrale Schwingungsmasse 14 zusammen mit den peripheren Schwingungsmassen 44, 46 in y-Richtung bewegen kann. Die peripheren Schwingungsmassen 44, 46 können somit zusammen mit der zentralen Schwingungsmasse 14 in y-Richtung schwingen, wobei diese Schwingungen durch die Federelemente 24, 26 und durch die Reibpolster 28 gedämpft werden. In x-Richtung hingegen kann sich die zentrale Schwingungsmasse 14 unabhängig von und relativ zu den peripheren Schwingungsmassen 44, 46 bewegen.

Bei der beschriebenen Federanordnung sind die Federelemente 20, 22, 24, 26 zwischen der Tragstruktur 12 und den peripheren Schwingungsmassen 40, 42, 44, 46 angeordnet; sie sind nicht direkt an der zentralen Schwingungsmasse 14 befestigt. Im Allgemeinen kann es aber auch Federelemente geben, die einerseits an der Tragstruktur 12 und andererseits direkt an der zentralen Schwingungsmasse 14 befestigt sind. Derartige Federelemente können insbesondere zusätzlich zur oben beschriebenen Federanordnung vorhanden sein.

Bedarfsweise sind Zusatzgewichte 114, 116 oder Trimmgewichte sowohl an der zentralen Schwingungsmasse 14 als auch an allen oder ausgewählten peripheren Schwingungsmassen 40, 42, 44, 46 anbringbar, wie schematisch in FIG. 6 und 7 dargestellt. Die zentrale Schwingungsmasse 14 und die peripheren Schwingungsmassen 40, 42, 44, 46 sind dazu vorteilhafterweise mit entsprechenden, bevorzugt wieder lösbaren Befestigungsmitteln versehen.

Ein Beispiel der bereits erwähnten Spannvorrichtung 32 zur Einstellung definierter Reibkräfte auf die schwingenden Massen ist in FIG. 8 dargestellt. Ein von oben auf die jeweilige Masse drückendes Reibpolster 30 wird hier durch ein sich an einem Teil der Tragstruktur 12 abstützenden Federelement 120 unter der gewünschten Spannung gehalten. Im vorliegenden Beispiel ist das Federelement 120 eine Tellerfeder oder ein Tellerfederpaket, aber natürlich können auch andere Federtypen zum Einsatz kommen, etwa Schraubenfedern (Druckfedern) oder Federringe. Durch eine Einstellschraube 122 kann vorteilhafterweise die Vorspannung gezielt eingestellt und geändert werden.

Im vorliegenden Fall durchsetzt der mit einem Gewinde versehene Schraubenschaft 124 der Einstellschraube 122 eine Spiel aufweisende Bohrung 126 in einem Träger 128 der Tragstruktur 12. Oben liegt der Schraubenkopf 130 der Einstellschraube 122 auf dem Träger 128 auf. Unterhalb des Trägers 128 ist eine Tellerfeder 132 zwischen dem Träger 128 und einer auf den Schraubenschaft 124 geschraubten Mutter 134 eingespannt und drückt die Einstellschraube 122 nach unten. Eine nach unten vom Träger 128 abstehende Einfassung 126 blockiert die Mutter 134 gegen Verdrehen. Dadurch kann durch Drehen des Schraubenkopfes 130 der Schraubenschaft 124 relativ zur feststehenden Mutter 134 nach oben oder unten bewegt und die Federvorspannung variiert werden.

Das beschriebene System bietet mannigfache Einstellmöglichkeiten, nämlich durch Auswahl und Einstellung der schwingenden Massen sowie der Federtypen, Federwege, Federkonstanten etc. Außerdem kann durch Auswahl der Reibflächen und des Anpressdrucks (Vorspannung) die Reibung des schwingenden Systems gezielt beeinflusst werden. Insbesondere können die Schwingungseigenschaften in x- und y-Richtung unterschiedlich (differentiell) eingestellt werden, so dass mit diesen Richtungen assoziierte unterschiedliche Eigenmoden des zu dämpfenden Systems, hier des Schaltschranks, berücksichtigt werden können.

Rein beispielhaft werden abschließend noch ein paar typische Dimensionen des Schwingungstilgers 8 für die bevorzugte Anwendung bei einem Schaltschrank 2 angegeben:
Die zentrale Schwingungsmasse 14 hat vorzugsweise ein Gewicht im Bereich von 10 bis 30 kg, die peripheren Schwingungsmassen 40, 42, 44, 46 haben jeweils vorzugsweise ein Gewicht im Bereich von 1 bis 10 kg. Das bevorzugte Material für die Schwingungsmassen ist Stahl. Die maximale Auslenkung der zentralen Schwingungsmasse 14 (Verstellweg) beträgt vorteilhafterweise zumindest einige Zentimeter in jeder der beiden Richtungen. Quer- und Längsabmessungen des Schwingungstilgers 8 sind adaptiert, so dass sie zu den Dimensionen der Deckenwand 6 des Schaltschranks 2 passen. Typischerweise sind diese Dimensionen im Bereich von 0,4 bis 1 m. Die Höhe des Schwingungstilgers 8 liegt im Bereich von 20 cm bis 30 cm. Die Federelemente 20, 22, 24, 26 haben eine Steifigkeit - diese, zusammen mit den schwingenden Massen, ergibt die Eigenfrequenz für das System im definierten Bereich von 5 bis 30 Hz. Diese Federelemente können vorteilhafterweise einige Zentimeter gestaucht oder gestreckt werden. Die Reibpolster-Materialien können bevorzugt Reibungskoeffizienten im Bereich von 0,05 bis 0.2 enthalten.

Wie aus der gesamten bisherigen Beschreibung hervorgeht, handelt es sich bei dem erfindungsgemäßen Schwingungstilger bevorzugt um einen rein passiven Schwingungstilger, bei denen die schwingenden Massen bei entsprechender seismischer Anregung gedämpft schwingen, aber selber über keine Antriebmittel in Form von Aktoren / Motoren oder dergleichen verfügen oder damit gekoppelt sind. Der erfindungsgemäße Schwingungstilger benötigt also zum Betrieb keine Steuerung und keine Energiezufuhr.

Wie bereits erwähnt liegt eine bevorzugte Anwendung des erfindungsgemäßen Schwingstilgers im Bereich von Schaltschränken, insbesondere elektrischen oder I&C Schaltschränken von Kernkraftwerken. Selbstredend kommen Anwendungen des erfindungsgemäßen Schwingungstilgers auch in anderen Bereichen in Betracht, etwa bei Gebäuden.

### Bezugszeichenliste

- 2: Schaltschrank
- 4: Tür
- 6: Deckenwand
- 8: Schwingungstilger
- 10: Halteelement
- 12: Tragstruktur
- 14: zentrale Schwingungsmasse
- 16: Zentralkörper
- 20: Federelement
- 22: Federelement
- 24: Federelement
- 26: Federelement
- 28: Reibpolster
- 30: Reibpolster
- 32: Spannvorrichtung
- 40: periphere Schwingungsmasse
- 42: periphere Schwingungsmasse
- 44: periphere Schwingungsmasse
- 46: periphere Schwingungsmasse
- 50: Ausleger
- 52: Basis
- 54: Träger
- 56: Schenkel
- 58: Befestigungspunkt
- 60: Flachprofil
- 62: Flachprofil
- 70: Führungselement
- 72: Führungselement
- 74: Führungselement
- 76: Führungselement
- 80: Deckelplatte
- 82: Führungselement
- 90: Vertikalträger
- 92: Vertikalträger
- 100: Führungselement
- 102: Führungselement
- 104: Führungselement
- 106: Führungselement
- 110: Feder
- 112: Verbindungsplatte
- 114: Zusatzgewicht
- 116: Zusatzgewicht
- 120: Federelement
- 122: Einstellschraube
- 124: Schraubenschaft
- 126: Bohrung
- 128: Träger
- 130: Schraubenkopf
- 132: Tellerfeder
- 134: Mutter
- 136: Einfassung

## Patentansprüche

1. Passiver Schwingungstilger (8), insbesondere für einen Schaltschrank (2), mit einer eine Längsrichtung (y) und eine Querrichtung (x) aufweisenden Tragstruktur (12) und mit einer mittels Federelementen (20, 22, 24, 26) in Längsrichtung (y) und Querrichtung (x) schwingend gelagerten zentralen Schwingungsmasse (14), wobei zumindest eine periphere Schwingungsmasse (40, 42) in Längsrichtung (y) gleitend auf der zentralen Schwingungsmasse (14) gelagert und relativ zu ihr beweglich ist, und wobei zumindest eine periphere Schwingungsmasse (44, 46) in Querrichtung (x) gleitend auf der zentralen Schwingungsmasse (14) gelagert und relativ zu ihr beweglich ist,
**dadurch gekennzeichnet, dass**
jede der peripheren Schwingungsmassen (40, 42, 44, 46) mittels einer Anzahl von Federelementen (20, 22, 24, 26) an der Tragstruktur (12) befestigt ist.

2. Schwingungstilger (8) nach Anspruch 1, wobei die in Längsrichtung (y) gleitend auf der zentralen Schwingungsmasse (14) gelagerte periphere Schwingungsmasse (40, 42) in Querrichtung (x) fest an die zentrale Schwingungsmasse (14) gekoppelt ist, und wobei die in Querrichtung (x) gleitend auf der zentralen Schwingungsmasse (14) gelagerte periphere Schwingungsmasse (44, 46) in Längsrichtung (y) fest an die zentrale Schwingungsmasse (14) gekoppelt ist.

3. Schwingungstilger (8) nach Anspruch 1 oder 2, wobei die die in Längsrichtung (y) gleitend auf der zentralen Schwingungsmasse (14) gelagerte periphere Schwingungsmasse (40, 42) in Querrichtung (x) schwingend gegenüber der Tragstruktur (12) gelagert ist, und wobei die in Querrichtung (x) gleitend auf der zentralen Schwingungsmasse (14) gelagerte periphere Schwingungsmasse (44, 46) in Längsrichtung (y) schwingend gegenüber der Tragstruktur (12) gelagert ist.

4. Schwingungstilger (8) nach einem der vorherigen Ansprüche, wobei die zentrale Schwingungsmasse (14) nur indirekt über die direkt mit den peripheren Schwingungsmassen (40, 42, 44, 46) verbundenen Federelemente (20, 22, 24, 26) federnd mit der Tragstruktur (12) verbunden ist.

5. Schwingungstilger (8) nach einem der vorherigen Ansprüche, wobei das jeweilige Federelement (20, 22, 24, 26) eine bevorzugt aus Drahtseil gebildete Feder (110) ist, die derart angeordnet ist, dass sie senkrecht zu ihrer Längsrichtung beansprucht wird.

6. Schwingungstilger (8) nach einem der vorherigen Ansprüche, wobei eine Drehung der zentralen Schwingungsmasse (14) gegenüber der Tragstruktur (12) durch Führungselemente (70, 72, 74, 76) verhindert ist.

7. Schwingungstilger (8) nach einem der vorherigen Ansprüche, wobei die zentrale Schwingungsmasse (14) einen Zentralkörper (16) aufweist sowie davon zu beiden Seiten hin in Quer- und Längsrichtung (x, y) abstehende Führungselemente (100, 102, 104, 106), auf denen die zugeordneten peripheren Massen (40, 42, 44, 46) gleiten.

8. Schwingungstilger (8) nach einem der vorherigen Ansprüche mit zwei in Längsrichtung (y) gleitend auf der zentralen Schwingungsmasse (14) gelagerten und relativ zu ihr beweglichen peripheren Schwingungsmassen (40, 42) und mit zwei in Querrichtung (x) gleitend auf der zentralen Schwingungsmasse (14) gelagerten und relativ zu ihr beweglichen peripheren Schwingungsmassen (44, 46).

9. Schwingungstilger (8) nach Anspruch 8, wobei die peripheren Schwingungsmassen (40, 42, 44, 46) eine kreuzförmige Anordnung bilden, mit der zentralen Schwingungsmasse (14) im Zentrum.

10. Schwingungstilger (8) nach einem der vorherigen Ansprüche, wobei eine Dämpfung des die zentrale Schwingungsmasse (14) und die peripheren Schwingungsmassen (40, 42, 44, 46) umfassenden schwingenden Systems durch Trockendämpfer verwirklicht ist.

11. Schwingungstilger (8) nach Anspruch 10, wobei zumindest ein Trockendämpfer vorhanden ist, der ein Reibpolster (28, 30) aufweist, welches an der zentralen Schwingungsmasse (14) anliegt.

12. Schwingungstilger (8) nach Anspruch 11, wobei zumindest ein Reibpolster (30) durch eine einstellbare Spannvorrichtung (32) gegen die zentrale Schwingungsmasse (14) gedrückt wird.

13. Schwingungstilger (8) nach einem der vorherigen Ansprüche, wobei die zentrale Schwingungsmasse (14) schwerer ist als die jeweilige periphere Schwingungsmasse (40, 42, 44, 46).

14. Schwingungstilger (8) nach einem der vorherigen Ansprüche, wobei eine Dämpfung des die zentrale Schwingungsmasse (14) und die peripheren Schwingungsmassen (40, 42, 44, 46) umfassenden schwingenden Systems unter Verzicht auf viskose Dämpfer verwirklicht ist.

15. Schwingungstilger (8) nach einem der vorherigen Ansprüche, wobei die zentrale Schwingungsmasse (14) und/oder die peripheren Schwingungsmassen (40, 42, 44, 46) Aufnahmen oder Befestigungsmöglichkeiten für Zusatzgewichte (114, 116) aufweisen.

16. Schaltschrank (2) mit einem Schwingungstilger (8) nach einem der vorherigen Ansprüche.

17. Schaltschrank (2), nach Anspruch 16, wobei der Schwingungstilger (8) in Längsrichtung (y) und Querrichtung (x) durch die die zentrale Schwingungsmasse (14) und/oder durch die peripheren Schwingungsmassen (40, 42, 44, 46) und/oder durch die Federelemente (20, 22, 24, 26) und /oder durch Trockendämpfer und/oder durch Zusatzgewichte (114, 116) an unterschiedliche Schwingungsfrequenzen adaptiert ist.

## Claims

1. Passive vibration damper (8), in particular for a switch cabinet (2), with a supporting structure (12) which has a longitudinal direction (y) and a transverse direction (x), and with a central oscillating mass (14) mounted to oscillate in the longitudinal direction (y) and transverse direction (x) by means of spring elements (20, 22, 24, 26), where at least one peripheral oscillating mass (40, 42) is mounted so as to slide on the central oscillating mass (14) in the longitudinal direction (y) and is movable relative thereto, and where at least one peripheral oscillating mass (44, 46) is movable in the transverse direction (x) mounted on the central oscillating mass (14) in the transverse direction and movable relative thereto,
**characterized in that**
each of the peripheral oscillating masses (40, 42, 44, 46) is attached to the support structure (12) by means of a number of spring elements (20, 22, 24, 26).

2. Vibration damper (8) according to claim 1, wherein the peripheral vibration mass (40, 42) mounted to slide in the longitudinal direction (y) on the central vibration mass (14) is coupled fixedly in the transverse direction (x) to the central vibration mass (14), and where the peripheral vibration mass (44, 46) mounted to slide in the transverse direction (x) on the central vibration mass (14) is coupled fixedly in the longitudinal direction (y) to the central vibration mass (14).

3. Vibration damper (8) according to claim 1 or 2, where the peripheral vibration mass (40, 42) mounted to slide in the longitudinal direction (y) on the central vibration mass (14) is mounted to oscillate in the transverse direction (x) with respect to the supporting structure (12), and where the peripheral vibration mass (44, 46) is mounted to slide on the central vibration mass (14) in the transverse direction (x) so as to oscillate in the longitudinal direction (y) relative to the supporting structure (12).

4. Vibration damper (8) according to any one of the preceding claims, where the central vibrating mass (14) is resiliently connected to the supporting structure (12) only indirectly via the spring elements (20, 22, 24, 26) directly connected to the peripheral vibrating masses (40, 42, 44, 46).

5. Vibration damper (8) according to any one of the preceding claims, where the respective spring element (20, 22, 24, 26) is a spring (110) preferably formed of wire rope and arranged to be stressed perpendicular to its longitudinal direction.

6. Vibration damper (8) according to any one of the preceding claims, where rotation of the central oscillating mass (14) relative to the supporting structure (12) is prevented by guide elements (70, 72, 74, 76).

7. Vibration damper (8) according to one of the previous claims, where the central vibrating mass (14) comprises a central body (16) as well as guide elements (100, 102, 104, 106) projecting therefrom on both sides in the transverse and longitudinal direction (x, y), on which the associated peripheral masses (40, 42, 44, 46) slide.

8. Vibration damper (8) according to one of the previous claims with two peripheral vibration masses (40, 42) mounted to slide in the longitudinal direction (y) on the central vibration mass (14) and movable relative thereto and with two peripheral vibration masses (44, 46) mounted to slide in the transverse direction (x) on the central vibration mass (14) and movable relative thereto.

9. Vibration damper (8) according to claim 8, where the peripheral vibration masses (40, 42, 44, 46) form a cross-shaped arrangement with the central vibration mass (14) in the centre.

10. Vibration damper (8) according to one of the previous claims, where a damping of the vibrating system comprising the central vibrating mass (14) and the peripheral vibrating masses (40, 42, 44, 46) is realised by dry dampers.

11. Vibration damper (8) according to claim 10, where at least one dry damper is provided which has a friction pad (28, 30) fitted closely against the central vibration mass (14).

12. Vibration damper (8) according to claim 11, where at least one friction pad (30) is pressed against the central vibration mass (14) by an adjustable tensioning device (32).

13. Vibration damper (8) according to any one of the preceding claims, whereby the central vibrating mass (14) is heavier than the respective peripheral vibrating mass (40, 42, 44, 46).

14. Vibration damper (8) according to any one of the preceding claims, whereby damping of the vibrating system comprising the central vibrating mass (14) and the peripheral vibrating masses (40, 42, 44, 46) is realised without viscous dampers.

15. Vibration damper (8) according to any one of the preceding claims, whereby the central vibration mass (14) and/or the peripheral vibration masses (40, 42, 44, 46) have receptacles or attachment possibilities for additional weights (114, 116).

16. Switch cabinet (2) with a vibration damper (8) according to one of the previous claims.

17. Switch cabinet (2) according to claim 16, where the vibration damper (8) is adapted to different vibration frequencies in the longitudinal direction (y) and transverse direction (x) by the central vibration mass (14) and/or by the peripheral vibration masses (40, 42, 44, 46) and/or by the spring elements (20, 22, 24, 26) and/or by dry dampers and/or by additional weights (114, 116).

## Revendications

1. Amortisseur à masse accordée (8) passif, en particulier pour une armoire de commande (2), avec une structure porteuse (12) présentant une direction longitudinale (y) et une direction transversale (x) et avec une masse oscillante centrale (14) montée oscillante dans la direction longitudinale (y) et la direction transversale (x) au moyen d'éléments ressorts (20, 22, 24, 26), dans lequel au moins une masse oscillante périphérique (40, 42) est montée coulissante dans la direction longitudinale (y) sur la masse oscillante centrale (14) et mobile par rapport à celle-ci, et dans lequel au moins une masse oscillante périphérique (44, 46) est montée coulissante dans la direction transversale (x) sur la masse oscillante centrale (14) et mobile par rapport à celle-ci,
**caractérisé en ce que**
chacune des masses oscillantes périphériques (40, 42, 44, 46) est fixée à la structure de support (12) au moyen d'un certain nombre d'éléments ressorts (20, 22, 24, 26).

2. Amortisseur à masse accordée (8) selon la revendication 1, dans lequel la masse oscillante périphérique (40, 42) montée coulissante dans la direction longitudinale (y) sur la masse oscillante centrale (14) est accouplée fixement dans la direction transversale (x) à la masse oscillante centrale (14), et dans lequel la masse oscillante périphérique (44, 46) montée coulissante dans la direction transversale (x) sur la masse oscillante centrale (14) est accouplée fixement à la masse oscillante centrale (14) dans la direction longitudinale (y).

3. Amortisseur à masse accordée (8) selon la revendication 1 ou 2, dans lequel la masse oscillante périphérique (40, 42) montée dans la direction longitudinale (y) sur la masse oscillante centrale (14) est montée oscillante dans la direction transversale (x) par rapport à la structure porteuse (12), et dans lequel la masse oscillante périphérique (44, 46) montée coulissante dans la direction transversale (x) sur la masse oscillante centrale (14) est montée oscillante dans la direction longitudinale (y) par rapport à la structure porteuse (12).

4. Amortisseur à masse accordée (8) selon l'une quelconque des revendications précédentes, dans lequel la masse oscillante centrale (14) n'est reliée élastiquement à la structure porteuse (12) qu'indirectement par l'intermédiaire des éléments ressorts (20, 22, 24, 26) directement reliés aux masses oscillantes périphériques (40, 42, 44, 46).

5. Amortisseur à masse accordée (8) selon l'une quelconque des revendications précédentes, dans lequel l'élément ressort (20, 22, 24, 26) respectif est un ressort (110) de préférence formé d'un câble métallique, qui est disposé de telle sorte qu'il est sollicité perpendiculairement à sa direction longitudinale.

6. Amortisseur à masse accordée (8) selon l'une quelconque des revendications précédentes, dans lequel une rotation de la masse oscillante centrale (14) par rapport à la structure porteuse (12) est empêchée par des éléments de guidage (70, 72, 74, 76).

7. Amortisseur à masse accordée (8) selon l'une quelconque des revendications précédentes, dans lequel la masse oscillante centrale (14) présente un corps central (16) ainsi que des éléments de guidage (100, 102, 104, 106) faisant saillie des deux côtés de celui-ci dans les directions transversale et longitudinale (x, y), sur lesquels coulissent les masses périphériques (40, 42, 44, 46) associées.

8. Amortisseur à masse accordée (8) selon l'une quelconque des revendications précédentes avec deux masses oscillantes périphériques (40, 42) montées coulissantes dans la direction longitudinale (y) sur la masse oscillante centrale (14) et mobiles par rapport à celle-ci et avec deux masses oscillantes périphériques (44, 46) montées coulissantes dans la direction transversale (x) sur la masse oscillante centrale (14) et mobiles par rapport à celle-ci.

9. Amortisseur à masse accordée (8) selon la revendication 8, dans lequel les masses oscillantes périphériques (40, 42, 44, 46) forment un agencement en forme de croix, avec la masse oscillante centrale (14) au centre.

10. Amortisseur à masse accordée (8) selon l'une quelconque des revendications précédentes, dans lequel un amortissement du système oscillant comprenant la masse oscillante centrale (14) et les masses oscillantes périphériques (40, 42, 44, 46) est réalisé par des amortisseurs à sec.

11. Amortisseur à masse accordée (8) selon la revendication 10, dans lequel il existe au moins un amortisseur à sec qui présente un coussin de friction (28, 30), lequel s'applique contre la masse oscillante centrale (14).

12. Amortisseur à masse accordée (8) selon la revendication 11, dans lequel au moins un coussin de friction (30) est pressé contre la masse oscillante centrale (14) par un dispositif de serrage réglable (32).

13. Amortisseur à masse accordée (8) selon l'une quelconque des revendications précédentes, dans lequel la masse oscillante centrale (14) est plus lourde que la masse oscillante périphérique (40, 42, 44, 46) respective.

14. Amortisseur à masse accordée (8) selon l'une quelconque des revendications précédentes, dans lequel un amortissement du système oscillant comprenant la masse oscillante centrale (14) et les masses oscillantes périphériques (40, 42, 44, 46) est réalisé en renonçant à des amortisseurs visqueux.

15. Amortisseur à masse accordée (8) selon l'une quelconque des revendications précédentes, dans lequel la masse oscillante centrale (14) et/ou les masses oscillantes périphériques (40, 42, 44, 46) présentent des logements ou possibilités de fixation pour des poids supplémentaires (114, 116).

16. Armoire de commande (2) avec un amortisseur à masse accordée (8) selon l'une quelconque des revendications précédentes.

17. Armoire de commande (2), selon la revendication 16, dans laquelle l'amortisseur à masse accordée (8) est adapté à différentes fréquences d'oscillation dans la direction longitudinale (y) et la direction transversale (x) par la masse oscillante centrale (14) et/ou par les masses oscillantes périphériques (40, 42, 44, 46) et/ou par les éléments ressorts (20, 22, 24, 26) et/ou par des amortisseurs à sec et/ou par des poids supplémentaires (114, 116).
